# EUROPEAN PATENT APPLICATION

(11) **EP 4 589 317 A1**
(43) Date of publication of application: **23.07.2025**
(21) Application number: 23855806.8
(22) Date of filing: 24.01.2023
(51) Int. Cl.: G01R 31/392, G01R 31/382, G01R 31/385, G01R 31/396, H01M 10/48, H02J 7/00

(54) **INFORMATION PROCESSING DEVICE, INFORMATION PROCESSING METHOD, COMPUTER PROGRAM, AND INFORMATION PROCESSING SYSTEM**

(30) Priority: 16.09.2022 JP 2022148436
(71) Applicant: Kabushiki Kaisha Toshiba, Minato-ku Tokyo 105-0023 (JP)
(72) Inventor: MARUCHI, Kohei, Tokyo 105-0023 (JP); YAMAMOTO, Takahiro, Tokyo 105-0023 (JP); HATANO, Hisaaki, Tokyo 105-0023 (JP)
(74) Representative: Hoffmann Eitle
(86) International application number: PCT/JP2023/002120
(87) International publication number: WO 2024/057568

(57) **Abstract**

[Problem to be solved] To provide an information processing apparatus, an information processing method, a computer program, and an information processing system capable of correctly determining a state of a storage battery.

[Solution] The information processing apparatus of the present embodiment includes a processor configured to: acquire a plurality of pieces of operation data including a minimum voltage among voltages of a plurality of battery cells, and a maximum voltage among the voltages of the plurality of battery cells, the plurality of battery cells being included in a rechargeable battery, and identification information identifying between charge or discharge of the rechargeable battery; generate, based on the plurality of pieces of operation data, evaluation target voltages by combining one of maximum voltages of the charge and minimum voltages of the charge and one of maximum voltages of the discharge and minimum voltages of the discharge; and determine, based on a voltage distribution of the evaluation target voltages, a state of the rechargeable battery.

## Description

### [Technical Field]

The present embodiment relates to an information processing apparatus, an information processing method, a computer program, and an information processing system.

### [Background Art]

There has been increased usage of a secondary battery (rechargeable battery) for the purposes of stabilizing a power system and reducing exhaust gas for decarbonization, and the like. Even if a rechargeable battery is normally working, deterioration will gradually progress in accordance with frequency of use or time of use. To avoid sudden failure of the rechargeable battery, there is a need to monitor the degree of progress of deterioration (State of Health) as a state of the rechargeable battery.

As an example, the rechargeable battery is constructed as an aggregate of battery modules where the battery modules are connected in series or in parallel, and the battery modules themselves are also an aggregate of battery cells. Thus, in order to correctly recognize an anomaly in the rechargeable battery, it is ideal to determine presence/absence of an anomaly (anomaly determination) at a module level or a cell level. However, operation data at the module or cell level is needed to realize the anomaly determination. As the scale of the rechargeable battery becomes larger, the number of modules and cells also becomes larger, and accumulation of data at the module level and the cell level is often difficult.

For this problem, there is a method of determining presence/absence of local deterioration by considering a state of each battery module from the operation data of the rechargeable battery. However, when using this method, if cell imbalance is occurring, the cell imbalance may be detected as an anomaly even if local deterioration is not occurring. In this case, it is not possible to determine whether local deterioration is occurring or cell imbalance is occurring.

### [Citation List]

### [Patent Literature]

[Patent Literature 1] International Publication No. 2021/044635
[Patent Literature 2] Japanese Patent No. 6313502
[Patent Literature 3] International Publication No. 2022/049745

### [Summary of Invention]

### [Technical Problem]

The present embodiment provides an information processing apparatus, an information processing method, a computer program, and an information processing system capable of correctly determining a state of a storage battery.

### [Solution to Problem]

According to one embodiment, an information processing apparatus includes a processor. The processor is configured to acquire a plurality of pieces of operation data each including a minimum voltage among voltages of a plurality of battery cells in a rechargeable battery, and a maximum voltage among the voltages of the plurality of battery cells, the plurality of battery cells, and identification information identifying charge or discharge showing whether the rechargeable battery is charged or discharged. The processor is configured to generate, based on the plurality of pieces of operation data, evaluation target voltages by combining one of: maximum voltages in the pieces of operation data of the charge; and minimum voltages in the pieces of operation data of the charge and one of: maximum voltages of the discharge in the pieces of operation data; and minimum voltages of the discharge in the pieces of operation data. The processor is configured to determine a state of the rechargeable battery based on a voltage distribution of the evaluation target voltages.

### [Brief Description of Drawings]

FIG. 1 is a block diagram illustrating an example of a rechargeable battery monitor apparatus which is an information processing apparatus according to the present embodiment;
FIG. 2 illustrates a configuration example of an battery system as one aspect of a rechargeable battery;
FIG. 3A illustrates a configuration example of one module;
FIG. 3B illustrates an image of local deterioration and cell imbalance;
FIG. 4 illustrates an example of an operation DB;
FIG. 5 illustrates an example of a voltage distribution;
FIG. 6 illustrates another example of the voltage distribution;
FIG. 7 illustrates an example of a rechargeable battery monitor apparatus which is a modification of the apparatus of FIG. 1;
FIG. 8 illustrates an example of a determination logic;
FIG. 9 is a diagram for describing a case in which cell imbalance is occurring;
FIG. 10 is a diagram for describing a case in which local deterioration is occurring;
FIG. 11 is a diagram for describing a case in which both cell imbalance and local deterioration are occurring;
FIG. 12 is another diagram for describing the case in which both cell imbalance and local deterioration are occurring;
FIG. 13 is a flowchart showing an example of a processing of a determiner;
FIG. 14 illustrates an example of determination result data including, for each battery unit, a value of each ratio and presence/absence of the local deterioration or the cell imbalance;
FIG. 15 illustrates the determination result data including, for each battery unit, determination results in time series in a tabular form;
FIG. 16 illustrates an output example of data including the value of each ratio in time series;
FIG. 17 is a flowchart of a working example of the rechargeable battery monitor apparatus according to the present embodiment;
FIG. 18 illustrates an example of the rechargeable battery monitor apparatus as an information processing apparatus according to a second embodiment;
FIG. 19 illustrates an example of instance data;
FIG. 20 illustrates an example of the rechargeable battery monitor apparatus as an information processing apparatus according to a third embodiment; and
FIG. 21 illustrates a hardware configuration example of the rechargeable battery monitor apparatus according to an embodiment of the present invention.

### [Description of Embodiments]

Hereinafter, embodiments of the present invention will be described while referring to the drawings.

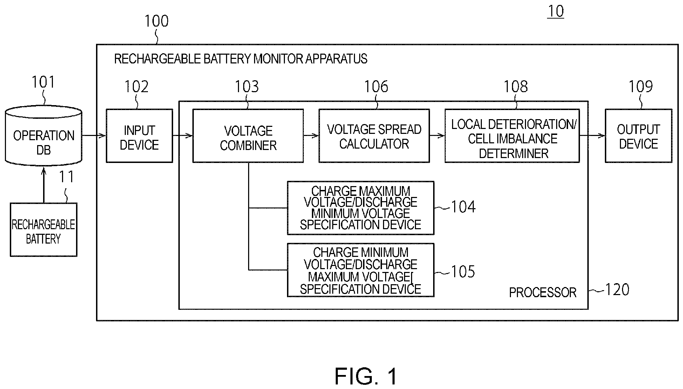

FIG. 1 is a block diagram of an example of an information processing system 10 including a rechargeable battery monitor apparatus 100 which is an information processing apparatus according to the present embodiment. The information processing system 10 includes a rechargeable battery 11, an operation DB 101, and the rechargeable battery monitor apparatus 100. The rechargeable battery monitor apparatus 100 includes an input device 102, a processor 120, and an output device 109.

The rechargeable battery 11 is a battery capable of repeating charge and discharge. The rechargeable battery 11 is also called a secondary battery in contrast with a primary battery which is only capable of discharge. However, hereinafter, this battery will be consistently referred to as the rechargeable battery. In the present embodiment, when referring to charge and discharge, at least either charge or discharge is included.

The use of the rechargeable battery 11 may be any use. As an example, the rechargeable battery 11 may be a rechargeable battery for power supply use which operates by accumulating electricity once such as a battery mounted on a mobile object working by using electric energy as its power source such as an electric vehicle (EV), an electric bus, an electric train, Light Rail Transit (LRT), Bus Rapid Transit (BRT), Automatic Guided Vehicle (AGV), an airplane, or a ship, or a battery mounted on industrial equipment or the like. Alternatively, the rechargeable battery may be a rechargeable battery such as a stationary rechargeable battery which is used for suppression of frequency fluctuations in a power system. The rechargeable battery may be a rechargeable battery for other uses. The rechargeable battery may be a battery for multiple uses aside from a single use. For example, the rechargeable battery may be a battery which is used as a power source of an EV or the like or for electric power storage of a demand repose by a reuse after being used for suppression of frequency fluctuations.

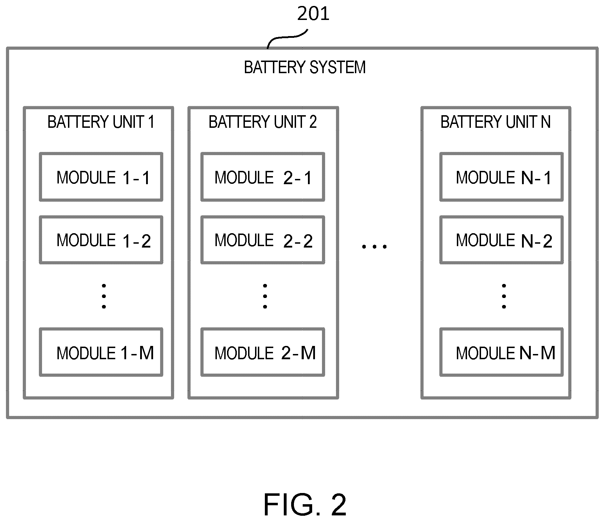

FIG. 2 illustrates a configuration example of an battery system 201 as one aspect of the rechargeable battery 11. The battery system 201 includes battery units (battery packs) 1, 2, ... N. A plurality of battery units are connected in series, in parallel, or in series and in parallel such that a desired output can be obtained in accordance with the use of the rechargeable battery. Each battery unit includes a plurality of modules. The battery unit 1 includes modules 1-1 to 1-M, the battery unit 2 includes modules 2-1 to 2-M, and the battery unit N includes modules N-1 to N-M. The plurality of modules in each battery unit are connected in series, in parallel, or in series and in parallel. The numbers of modules included in each battery unit are the same in the present example, but the numbers do not have to be the same.

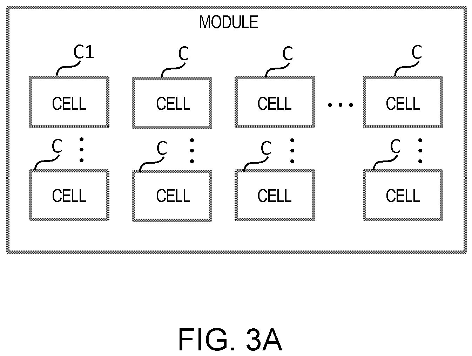

FIG. 3A illustrates a configuration example of one module. The module includes a plurality of battery cells C. The battery cells are also referred to as cells. The plurality of battery cells C are connected in series, in parallel, or in series and in parallel. As an example, two or more battery cells C are connected in series, and a plurality of these two or more battery cells C connected in series are connected in parallel.

The rechargeable battery (target rechargeable battery) to become the target for evaluation in the present embodiment is each battery unit, each module, or the battery system. The present apparatus 100 detects an anomaly in the rechargeable battery. More specifically, the present apparatus 100 determines presence/absence of cell imbalance and presence/absence of local deterioration in the rechargeable battery.

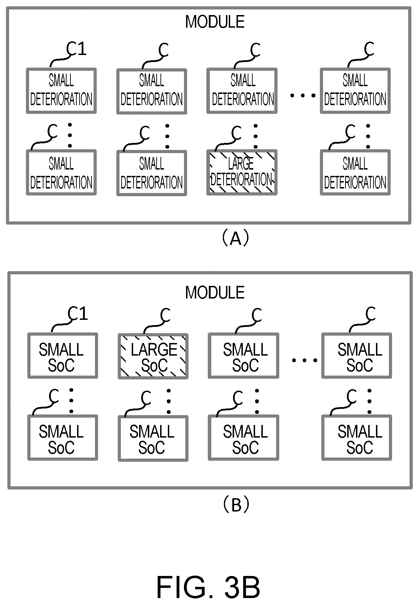

FIG. 3B(A) illustrates an image of local deterioration. The local deterioration is occurring in a cell C illustrated with oblique lines. The local deterioration refers to a situation where a part of a plurality of cells is locally deteriorated.

FIG. 3B(B) illustrates an image of cell imbalance. The amount of charge (SoC) of a cell C illustrated with oblique lines is large, and the amounts of charge of other cells C are small. That is, the amounts of charge of a plurality of cells C are varied. Cell imbalance, which is variation in the amounts of charge of a plurality of cells, is occurring. For example, the variation may be a situation where a standard deviation of the amounts of charge of a plurality of cells is a certain value or higher, may be a situation where a difference in the amounts of charge of any two cells is a certain value or higher, or may have other definitions.

The rechargeable battery monitor apparatus 100 is connected to the operation DB 101. The operation DB 101 stores operation data acquired from one or more rechargeable batteries 11 in time series. The operation data may be data acquired from a rechargeable battery during operation when the rechargeable battery is being used in its actual use, or may be data acquired by experiments. The unit of acquisition of the operation data may be any of a module, a battery unit, and a set of a plurality of battery units. The operation data may be acquired in a plurality of units of acquisition. The unit of acquisition of the operation data can be either of a module and a battery unit as long as it is an aggregate of battery cells. A maximum cell voltage and a minimum cell voltage are a voltage of a battery cell having the maximum voltage and a voltage of a battery cell having the minimum voltage among all battery cells in a unit of data acquisition. The voltage of a battery cell is also referred to as a cell voltage. Values of the maximum cell voltage and the minimum cell voltage are values that are recognized by the rechargeable battery or the battery system in order to prevent overcharging and over-discharging.

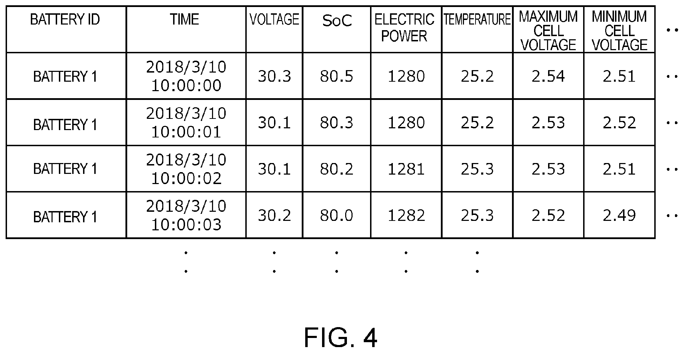

FIG. 4 illustrates an example of the operation DB 101. The operation data includes measurement data related to the rechargeable battery 11. More specifically, the operation data includes a battery ID, a time (measurement time), a voltage value, a State of Charge (SoC), an electric power value, a temperature, a maximum cell voltage, and a minimum cell voltage. The temperature is a temperature measured in the rechargeable battery 11. Distinction between charge and discharge of electric current or electric power can be made by plus/minus. In other words, plus/minus is an example of information for identifying charge or discharge. It may be configured such that the distinction between charge and discharge is made by providing charge and discharge flags such as during charge or during discharge. In this case, the charge and discharge flags correspond to the information for identifying charge or discharge.

Other pieces of information such as the use, humidity, or weather of the rechargeable battery 11 may be included in the operation data. For example, the operation data may also include a flag indicating a state of the rechargeable battery at the time of acquisition of measurement data from the rechargeable battery such as during charge, during discharge, during operation of the system (hereinafter, during operation), or during non-operation of the system (hereinafter, during non-operation). The kind of the flag may differ depending on the type of the rechargeable battery. As mentioned above, examples of the type of the rechargeable battery include a rechargeable battery used for suppression of frequency fluctuations in a power system and a rechargeable battery for storage (a rechargeable battery for an EV, and the like). In addition, the operation data may also include a value indicating a state of the rechargeable battery, specifically, a State of Health (SoH) of the rechargeable battery. The SoH indicates a degree of progress of deterioration of the rechargeable battery, and it is an index representing a deterioration state indicating how much the deterioration of the rechargeable battery is progressed. As an example, the SoH is defined as being obtained by dividing a battery capacity by a specification capacity of the rechargeable battery. However, the definition of the SoH is not limited thereto. For example, the SoH may be defined in accordance with a size of internal resistance.

In the example of FIG. 4, the operation data is acquired at 1-second intervals, but the acquisition interval may be another value such as 1 minute, 5 minutes, or 1 hour. In addition, the acquisition interval does not have to be fixed time intervals, and the acquisition interval may vary depending on, for example, periods of time, modes of use of the rechargeable battery, or the like. A voltage value is a charge voltage value when it is a voltage measured during charge, or is a discharge voltage value when it is a voltage measured during discharge. An electric current value may be included in the operation data instead of an electric power value. In this case, the rechargeable battery monitor apparatus 100 may calculate the electric power value by integrating the electric current value with the voltage value. The SoC is an index indicating the amount of charge of a battery. As an example, the SoC is calculated by dividing an electric power amount (electric charge amount) accumulated in the rechargeable battery by the specification capacity of the rechargeable battery. If the operation data does not include a SoC while including the electric current value, the rechargeable battery monitor apparatus 100 may integrate the electric current value and calculate the SoC from an integrated value.

The input device 102 acquires the operation data from the operation DB 101, and provides the operation data to a voltage combiner 103. The acquisition period of the operation data is a period that is the target of evaluation of the rechargeable battery 11.

A charge maximum voltage/discharge minimum voltage specification device 104 (hereinafter, the specification device 104) specifies a maximum cell voltage (hereinafter, the charge maximum voltage) for each operation data of charge among the operation data of the period, which is the target of evaluation, and acquires charge maximum voltages. In addition, a minimum cell voltage (hereinafter, the discharge minimum voltage) is specified for each operation data of discharge, and discharge minimum voltages are acquired. As mentioned above, distinction between charge and discharge in the operation data is made with plus/minus of the electric current or the electric power. For example, plus corresponds to discharge and minus corresponds to charge. When a flag of charge or discharge is included in the operation data, the distinction between charge and discharge may be made based on the flag.

A charge minimum voltage/discharge maximum voltage specification device 105 (hereinafter, the specification device 105) specifies a minimum cell voltage of charge (hereinafter, the charge minimum voltage) for each operation data of charge among the operation data of the period, which is the target of evaluation, and acquires charge minimum voltages. In addition, a maximum cell voltage of discharge (hereinafter, the discharge maximum voltage) is specified for each operation data of discharge, and discharge maximum voltages are acquired.

The voltage combiner 103 combines one of the charge maximum voltages and the charge minimum voltages and one of the discharge minimum voltages and the discharge maximum voltages acquired by the specification devices 104, 105 to generate evaluation target voltages. As an example, a set of the charge maximum voltages and the discharge minimum voltages, a set of the charge minimum voltages and the discharge maximum voltages, a set of the charge maximum voltages and the discharge maximum voltages, and a set of the charge minimum voltages and the discharge minimum voltages are each generated as the evaluation target voltages. Four sets (evaluation target voltages) are generated, but sets to be generated may be changed depending on the kinds of anomalies desired to be detected, which will be described later. For example, when detecting only whether at least cell imbalance is occurring, only the set of the charge minimum voltages and the discharge maximum voltages may be generated.

A voltage distribution of the set of the charge maximum voltages and the discharge minimum voltages will be described as a voltage distribution (the charge maximum voltages, the discharge minimum voltages), a voltage distribution of the set of the charge minimum voltages and the discharge maximum voltages will be described as a voltage distribution (the charge minimum voltages, the discharge maximum voltages), a voltage distribution of the set of the charge maximum voltages and the discharge maximum voltages will be described as a voltage distribution (the charge maximum voltages, the discharge maximum voltages), and a voltage distribution of the set of the charge minimum voltages and the discharge minimum voltages will be described as a voltage distribution (the charge minimum voltages, the discharge minimum voltages).

A voltage spread calculator 106 (feature calculator) calculates a feature related to spread of a voltage distribution (also referred to as the voltage spread degree) for each of the voltage distributions (the charge maximum voltages, the discharge minimum voltages), (the charge minimum voltages, the discharge maximum voltages), (the charge maximum voltages, the discharge maximum voltages), (the charge minimum voltages, the discharge minimum voltages). A specific example of the voltage spread degree will be shown by using the voltage distribution (the charge maximum voltages, the discharge minimum voltages) as an example.

As an example, the voltage spread degree is a standard deviation of the voltage distribution (the charge maximum voltages, the discharge minimum voltages). Alternatively, the voltage spread degree is a difference between a maximum value and a minimum value of the voltage distribution (the charge maximum voltages, the discharge minimum voltages). Alternatively, the voltage spread degree is a difference between a maximum value among the charge maximum voltages and a minimum value among the discharge minimum voltages in the voltage distribution (the charge maximum voltages, the discharge minimum voltages). The voltage spread degree may be defined by other methods.

In addition, the voltage spread calculator 106 calculates an average cell voltage (average voltage) for each operation data. For example, the average voltage can be calculated by dividing a voltage included in the operation data by a number of connection of cells in series. If the voltage of the operation data is data of modules or battery units, the average voltage of the cells can be calculated by dividing the voltage by the number of connection of the cells in series. The average voltage may be included in the operation data. In this case, the average voltage can be acquired from the operation data. The voltage spread calculator 106 sorts out the average voltage calculated for each operation data into an average voltage of charge (charge average voltage) and an average voltage of discharge (discharge average voltage) to acquire charge average voltages and discharge average voltages. A voltage distribution of the set of the charge average voltages and the discharge average voltages (reference voltages) will be described as a reference voltage distribution (the charge average voltages, the discharge average voltages). The voltage spread calculator 106 calculates the feature related to spread of a voltage distribution (voltage spread degree) also for the reference voltage distribution (the charge average voltages, the discharge average voltages). A calculation method of the voltage spread degree may be the same as the example mentioned above.

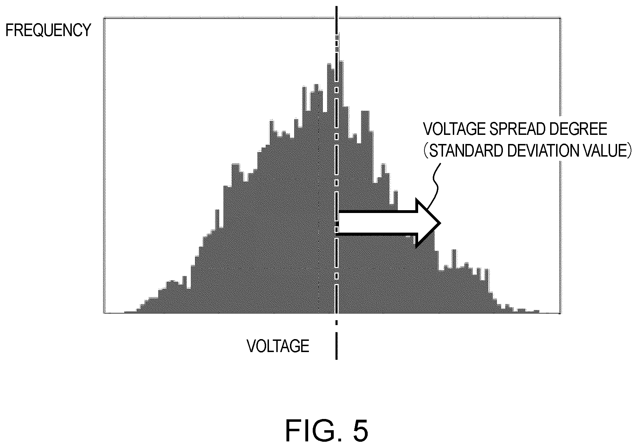

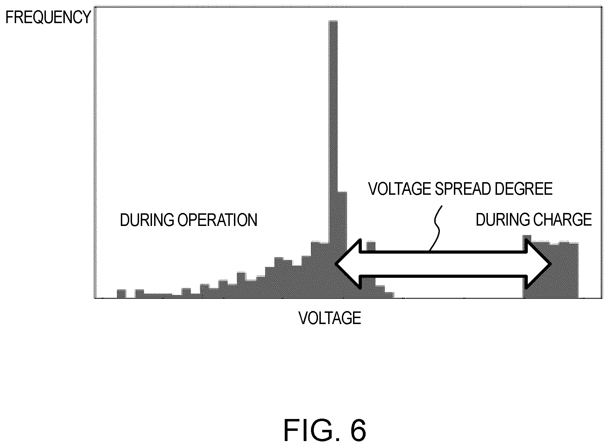

A calculation example of the voltage spread degree will be shown by using FIG. 5 and FIG. 6. Descriptions of FIG. 5 and FIG. 6 are also applicable to any of the above-mentioned five kinds of voltage spread degrees.

FIG. 5 illustrates an example of calculating the voltage spread degree from a voltage distribution. This voltage distribution may be any of the above-mentioned five kinds of voltage distributions. This distribution has a shape close to a normal distribution. This distribution can be obtained from a rechargeable battery to be used for adjustment of electric power such as a stationary rechargeable battery. In the case of such distribution, a standard deviation can be calculated as the voltage spread degree. FIG. 5 illustrates an example of calculating the standard deviation.

FIG. 6 illustrates another example of calculating the voltage spread degree from a voltage distribution. This distribution has two peaks which are during charge and during operation (during discharge). Such distribution can be obtained from a rechargeable battery for power supply use which operates by accumulating electricity once such as an electric mobile object or industrial equipment. In the case of such distribution, as the voltage spread degree, a difference between an average voltage during charge and an average voltage during discharge can be regarded as the voltage spread degree.

The present apparatus 100 may decide the use purpose of the rechargeable battery, and decide the kind of the spread degree of the voltage distribution (feature) to be calculated in accordance with the determined use purpose. A feature decider which decides the kind of the feature in accordance with the use purpose of the rechargeable battery may be provided for the rechargeable battery monitor apparatus 100 in FIG. 1.

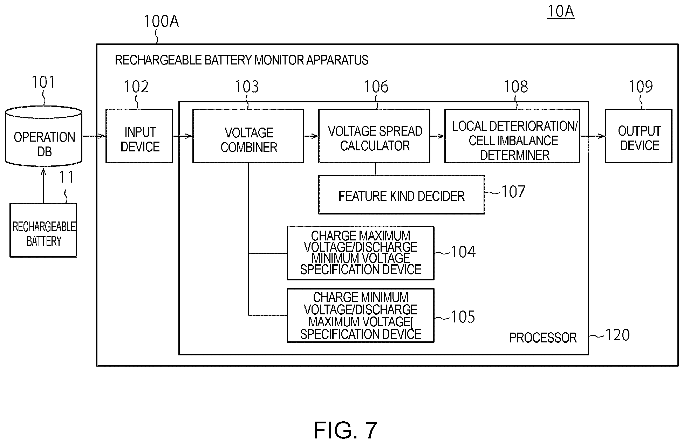

FIG. 7 illustrates an example of an information processing system 10A including a rechargeable battery monitor apparatus 100A which is a modification of the apparatus 100 in FIG. 1. A feature kind decider 107 is added. The feature kind decider 107 determines the use purpose of the rechargeable battery 11, and decides the kind of the feature to be calculated. As an example, the operation DB 101 stores classification information indicating the use purpose of the rechargeable battery 11, and the feature kind decider 107 may determine the use purpose of the rechargeable battery 11 based on the classification information. Alternatively, the feature kind decider 107 may determine the classification of the rechargeable battery 11 from the shapes (see FIG. 5 and FIG. 6) of the above-mentioned voltage distributions.

In addition, the rechargeable battery has a property that the Open Circuit Voltage (OCV) becomes higher as the amount of charge becomes larger. In order to exclude a difference in the Open Circuit Voltage, the voltage spread degree may be calculated in accordance with the SoC. Thus, the voltage combiner 103 may generate the above-mentioned five kinds of voltage combinations (evaluation target voltages) by targeting only the operation data having a specific SoC or the operation data belonging to a specific SoC range. The input device 102 may acquire only the operation data having the specific SoC or the operation data belonging to the specific SoC range from the operation DB 101.

Voltage spread degrees calculated from each of the above-mentioned five voltage distributions (the charge maximum voltages, the discharge minimum voltages), (the charge minimum voltages, the discharge maximum voltages), (the charge maximum voltages, the discharge maximum voltages), (the charge minimum voltages, the discharge minimum voltages), and (the charge average voltages, the discharge average voltages) will be described as voltage spread degrees (maximum-minimum), (minimum-maximum), (maximum-maximum), (minimum-minimum), and (average), respectively.

A local deterioration/cell imbalance determiner 108 (hereinafter, the determiner 108) performs a determination processing of determining, based on the voltage spread degrees (maximum-minimum), (minimum-maximum), (maximum-maximum), (minimum-minimum), and (average), whether at least either local deterioration or cell imbalance is occurring. As the result of the determination processing, there are four possibilities which are "local deterioration is occurring", "cell imbalance is occurring", "both local deterioration and cell imbalance are occurring", and "neither local deterioration nor cell imbalance is occurring".

The determiner 108 calculates ratios of the voltage spread degrees (maximum-minimum), (minimum-maximum), (maximum-maximum), and (minimum-minimum) to the voltage spread degree (average), to obtain ratios (maximum-minimum), (minimum-maximum), (maximum-maximum), and (minimum-minimum). That is to say, the ratios (maximum-minimum), (minimum-maximum), (maximum-maximum), and (minimum-minimum) are calculated by dividing the voltage spread degrees (maximum-minimum), (minimum-maximum), (maximum-maximum), and (minimum-minimum) by the voltage spread degree (average), respectively.

The determiner 108 compares the ratios (maximum-minimum), (minimum-maximum), (maximum-maximum), and (minimum-minimum) with at least one threshold, and based on a comparison result and a determination logic, determines presence/absence of local deterioration and presence/absence of cell imbalance.

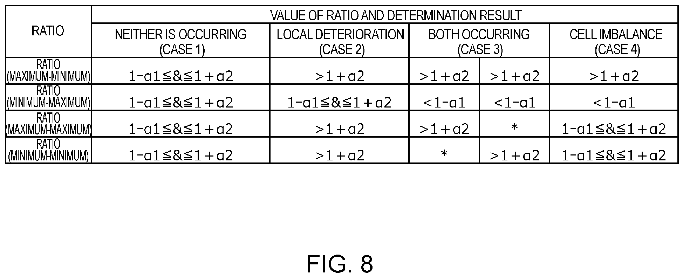

FIG. 8 illustrates an example of the determination logic as a determination table. For the ratios (maximum-minimum), (minimum-maximum), (maximum-maximum), and (minimum-minimum), a lower limit threshold and an upper limit threshold are used as two thresholds. The lower limit threshold is 1-α1, and the upper limit threshold is 1+α2. Both α1 and α2 are positive real numbers. α1 and α2 may be the same value or different values. In the example of FIG. 8, the same threshold is used for the ratios (maximum-minimum), (minimum-maximum), (maximum-maximum), and (minimum-minimum), but each of these may use different thresholds. For example, a lower limit threshold 1-β1 and an upper limit threshold 1+β2 may be used for the ratio (minimum-maximum), a lower limit threshold 1-γ1 and an upper limit threshold 1+γ2 may be used for the ratio (maximum-maximum), and a lower limit threshold 1-θ1 and an upper limit threshold 1+θ2 may be used for the ratio (minimum-minimum). The threshold is predetermined, and it may vary depending on the temperature or battery classification. In addition, the threshold may vary depending on a pattern of a charge and discharge command value executed by the rechargeable battery 11. The rechargeable battery 11 performs charge or discharge according to the charge and discharge command value at sampling intervals with an instructed electric power value. The charge and discharge command value may be estimated from an electric power value included in the operation data and information for identifying charge and discharge. Correspondence data in which a temperature, a battery classification, or a pattern of the charge and discharge command value is made to correspond with a threshold in advance is prepared, and by using this correspondence data, a threshold to be used is decided.

Hereinafter, the determination logic in FIG. 8 will be described.
[CASE 1] When all the ratios (maximum-minimum), (minimum-maximum), (maximum-maximum), and (minimum-minimum) are the lower limit threshold 1-α1 or more and the upper limit threshold 1+α2 or less, it is judged that neither local deterioration nor cell imbalance is occurring. If α1 and α2 are values significantly smaller as compared to 1, when all the ratios (maximum-minimum), (minimum-maximum), (maximum-maximum), and (minimum-minimum) are about 1, it can be recognized that neither local deterioration nor cell imbalance is occurring. In the present embodiment, α1 and α2 are values significantly smaller as compared to 1. For example, values of α1 and α2 are 0.1 or smaller. 0.1 is just an example, and a greater value may be set.
[CASE 2] When all the ratios (maximum-minimum), (maximum-maximum), and (minimum-minimum) are greater than the upper limit threshold 1+α2, and the ratio (minimum-maximum) is the lower limit threshold 1-α1 or more and the upper limit threshold 1+α2 or less, it is judged that local deterioration is occurring.
[CASE 3] When both the ratios (maximum-minimum) and (maximum-maximum) are greater than the upper limit threshold 1+α2 and the ratio (minimum-maximum) is smaller than the lower limit threshold 1-α1, it is judged that both local deterioration and cell imbalance are occurring. The ratio (minimum-minimum) may be any value. "*" in the diagram means "don't care" (the value may be any value).

Alternatively, when both the ratios (maximum-minimum) and (minimum-minimum) are greater than the upper limit threshold 1+α2 and the ratio (minimum-maximum) is smaller than the lower limit threshold 1-α1, it is judged that both local deterioration and cell imbalance are occurring. The ratio (maximum-maximum) may be any value.
[CASE 4] When the ratio (maximum-minimum) is greater than the upper limit threshold 1+α2, the ratio (minimum-maximum) is smaller than the lower limit threshold 1-α1, and both the ratios (maximum-maximum) and (minimum-minimum) are the lower limit threshold 1-α1 or more and the upper limit threshold 1+α2 or less, it is judged that cell imbalance is occurring.

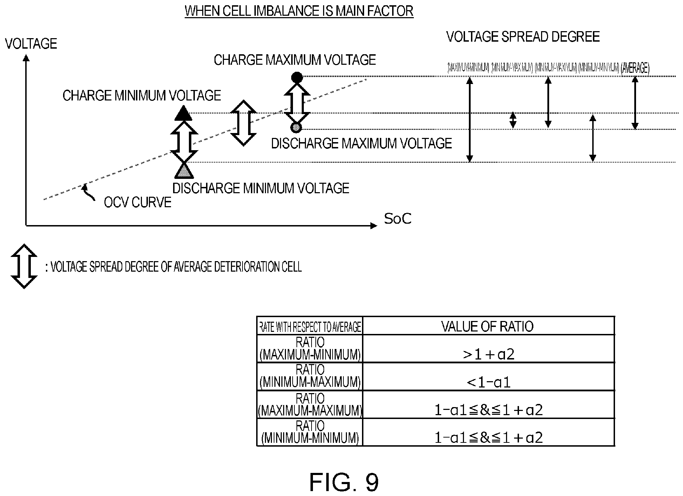

The basis of determination in the determination logic of FIG. 8 will be described in detail per case by using FIG. 9 to FIG. 12.

FIG. 9 is a diagram for describing a case in which cell imbalance is occurring. Descriptions will be made in association with a coordinate system where the horizontal axis is the SoC of the rechargeable battery 11 and the vertical axis is the voltage. The thick arrow in a longitudinal direction represents a voltage spread degree (average) of average deterioration cells. The broken line schematically expresses an OCV curve. In general, the OCV becomes higher as the amount of charge becomes larger, and the charge voltage and the discharge voltage also become accordingly higher.

Since local deterioration is not occurring, the voltage spread degree of the average deterioration cells will be about the same level in any SoC. Since cell imbalance is occurring, there is an average deterioration cell having a different SoC (here, not the SoC of the battery module or the battery unit, but the SoC of the cell). In such state, the charge maximum voltage, the charge minimum voltage, the discharge minimum voltage, and the discharge maximum voltage will be at the illustrated positions. Since local deterioration is not occurring, the average deterioration cells have both the charge maximum voltage and the discharge minimum voltage. The voltage spread degrees (maximum-minimum), (minimum-maximum), (maximum-maximum), (minimum-minimum), and (average) will be the sizes as shown in the ranges with arrows on the right side of the diagram. The voltage spread degree (maximum-minimum) is greater than the voltage spread degree (average), and the voltage spread degree (minimum-maximum) is smaller than the voltage spread degree (average).

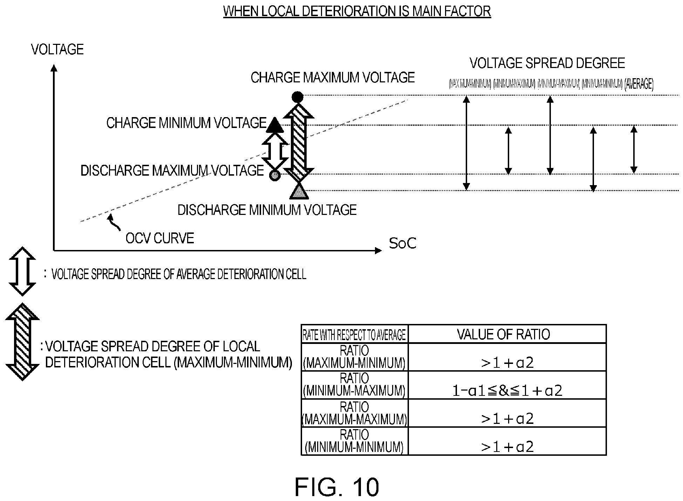

FIG. 10 is a diagram for describing a case in which local deterioration is occurring. Since the local deterioration is occurring, the voltage spread degree (maximum-maximum) is different from the case of the cell imbalance in FIG. 9, and is greater than the voltage spread degree (average). The voltage spread degree (maximum-minimum) is greater than the voltage spread degree (average) as in the case of the cell imbalance. However, although the average deterioration cells have both the charge maximum voltage and the discharge minimum voltage in the case of the cell imbalance, in the case of the local deterioration, a local deterioration cell has both the charge maximum voltage and the discharge minimum voltage (see the arrow with oblique lines in the longitudinal direction). The voltage spread degree (minimum-maximum) is about the same level as the voltage spread degree (average), and the voltage spread degree (minimum-minimum) is greater than the voltage spread degree (average).

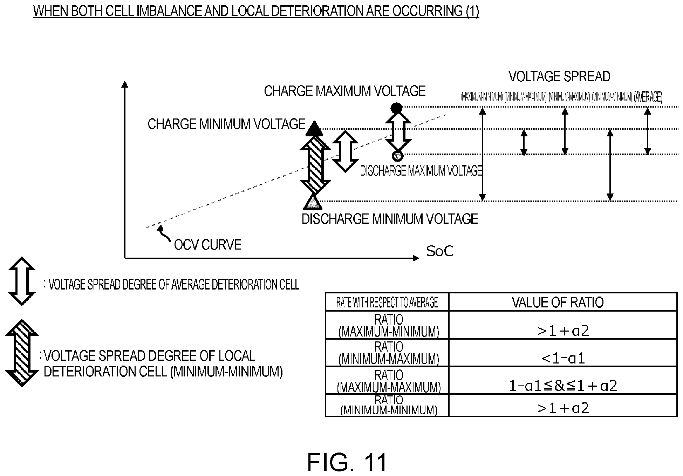

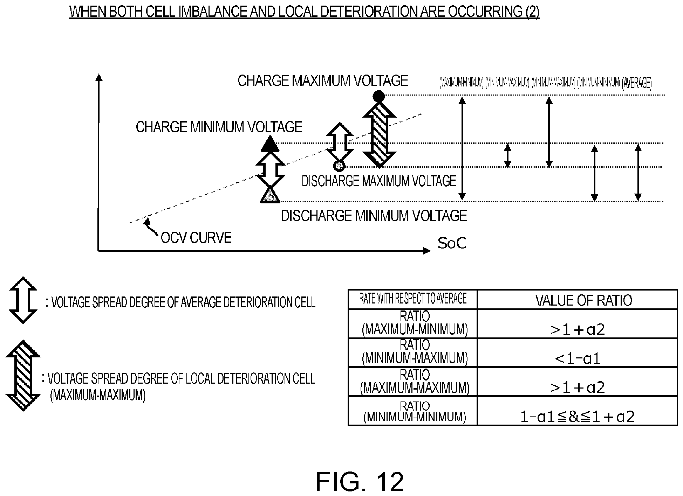

FIG. 11 and FIG. 12 are each diagram for describing a case in which both the cell imbalance and the local deterioration are occurring. In the case where both the cell imbalance and the local deterioration are occurring, the average deterioration cells have one of the charge maximum voltage and the discharge minimum voltage, and the local deterioration cell has the another. Since there are two patterns which are the case where the average deterioration cells have the charge maximum voltage and the case where the average deterioration cells have the discharge minimum voltage, two kinds of cases are separately shown as illustrated in FIG. 11 and FIG. 12.

FIG. 11 illustrates a case where the average deterioration cells have the charge maximum voltage, and the local deterioration cell has the discharge minimum voltage. FIG. 12 illustrates a case where the local deterioration cell has the charge maximum voltage, and the average deterioration cells have the discharge minimum voltage. When comparing FIG. 11 and FIG. 12, in FIG. 11, the voltage spread degree (maximum-maximum) and the voltage spread degree (average) are about the same level, while the voltage spread degree (minimum-minimum) is significantly greater than the voltage spread degree (average). On the other hand, in FIG. 12, the voltage spread degree (minimum-minimum) and the voltage spread degree (average) are about the same level, while the voltage spread degree (maximum-maximum) is significantly greater than the voltage spread degree (average). The voltage spread degree (maximum-minimum) is greater than the voltage spread degree (average) in both FIG. 11 and FIG. 12, and the voltage spread degree (minimum-maximum) is smaller than the voltage spread degree (average) in both FIG. 11 and FIG. 12.

A case where neither cell imbalance nor local deterioration is occurring is a case where the average deterioration cells have the same or substantially the same SoC (here, the SoC of the cell). Thus, the voltage spread degrees (maximum-minimum), (minimum-maximum), (maximum-maximum), and (minimum-minimum) will be about the same level as the voltage spread degree (average) (not illustrated).

By consolidating the results of separate cases illustrated in FIG. 9 to FIG. 12, the determination table illustrated in FIG. 8 can be derived.

In the determination table of FIG. 8, limited knowledge can be obtained by using some ratios. For example, by using only the ratio (minimum-maximum), it can be determined that at least cell imbalance is occurring if the ratio (minimum-maximum) is smaller than the lower limit threshold 1-α1. In addition, when only using the ratio (maximum-minimum), it can be determined that neither cell imbalance nor local deterioration is occurring if the ratio (maximum-minimum) is about 1 (the lower limit threshold or more and the upper limit threshold or less). If the ratio (maximum-minimum) is greater than the upper limit threshold, it can be determined that at least either cell imbalance or local deterioration is occurring.

The determination table of FIG. 8 illustrates a method of determining presence/absence of cell imbalance and local deterioration by using a rate with respect to the voltage spread degree (average), but the determination can be made by using a difference from the voltage spread degree (average). In that case, the lower limit threshold "1-α1" and the upper limit threshold "1+α2" in the determination table of FIG. 8 should be changed to a lower limit threshold "-α1" and an upper limit threshold "α2". That is to say, the determination is made based on whether each of differences between the voltage spread degrees (maximum-minimum), (minimum-maximum), (maximum-maximum), and (minimum-minimum) and the voltage spread degree (average) is about 0 (the lower limit threshold "-α1" or more and the upper limit threshold "α2" or less), greater than the upper limit threshold, or smaller than the lower limit threshold.

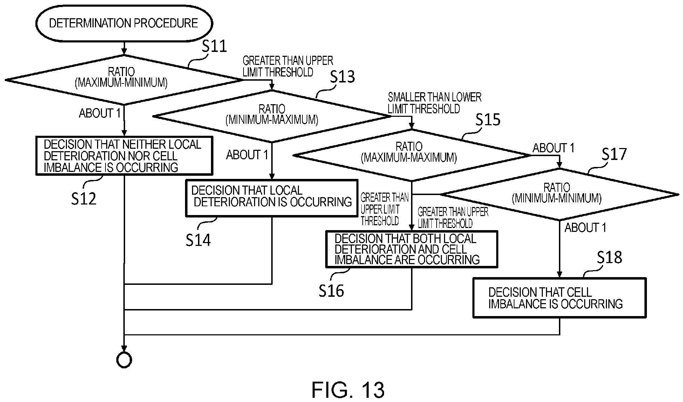

FIG. 13 is a flowchart showing an example of a processing of the determiner 108. The determiner 108 performs the processing with procedures based on the determination table of FIG. 8.

Whether the ratio (maximum-minimum) is about 1 (the lower limit threshold or more and the upper limit threshold or less) or greater than the upper limit threshold is judged (S11). If the ratio (maximum-minimum) is about 1, it is decided that neither local deterioration nor cell imbalance is occurring (S12). From the determination table of FIG. 8, the case where the ratio (maximum-minimum) is about 1 (the lower limit threshold or more and the upper limit threshold or less) is only the case where neither local deterioration nor cell imbalance is occurring. Thus, the judgment can be made without referring to values of other kinds of ratios.

If the ratio (maximum-minimum) is greater than the upper limit threshold, whether the ratio (minimum-maximum) is about 1 or smaller than the lower limit threshold is judged (S13). If the ratio (minimum-maximum) is about 1, it is decided that local deterioration is occurring (S14).

If the ratio (maximum-minimum) is smaller than the lower limit threshold, whether the ratio (maximum-maximum) is about 1 or greater than the upper limit threshold is judged (S15). If the ratio (maximum-maximum) is greater than the upper limit threshold, it is decided that both local deterioration and cell imbalance are occurring (S16).

If the ratio (maximum-maximum) is about 1, whether the ratio (minimum-minimum) is about 1 or greater than the upper limit threshold is judged (S17). If the ratio (minimum-minimum) is greater than the upper limit threshold, it is decided that both local deterioration and cell imbalance are occurring (S16). If the ratio (minimum-minimum) is about 1, it is decided that cell imbalance is occurring (S18).

The above-mentioned processing is an example, and other procedures may be used as long as those procedures comply with the determination table of FIG. 8. In addition, if it is decided that both local deterioration and cell imbalance are occurring in step S16, when the ratio (maximum-maximum) is greater than the upper limit threshold, knowledge that the imbalance of the amount of charge of the local deterioration cell is occurring toward the lower side can be obtained. In addition, when the ratio (minimum-minimum) is greater than the upper limit threshold, it is the opposite, i.e., knowledge that the imbalance of the amount of charge of the local deterioration cell is occurring toward the higher side can be obtained.

The output device 109 generates data indicating a determination result of the determiner 108, and outputs this data as determination result data. For example, the output device 109 outputs the determination result data to a display device which is browsable by a user.

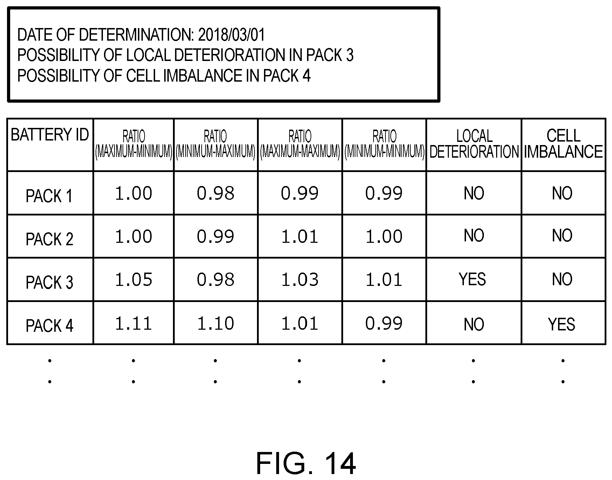

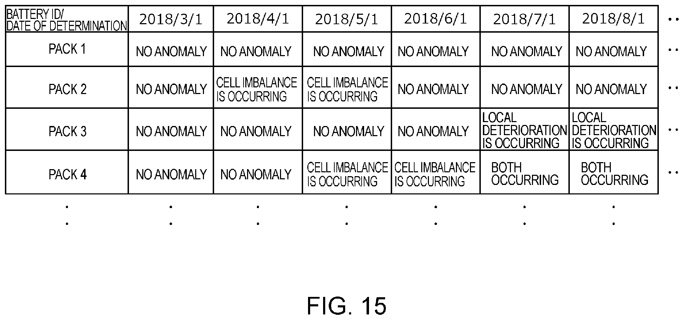

FIG. 14 and FIG. 15 each illustrate an example of the determination result data.

FIG. 14 illustrates an example of the determination result data including, for each battery unit (pack), a value of each ratio and presence/absence of an anomaly (local deterioration or cell imbalance). In the determination result data of FIG. 14, a battery unit (pack) determined to have an anomaly can be clearly recognized, and the value of each ratio at that time also can be confirmed.

FIG. 15 illustrates the determination result data including, for each battery unit (pack), determination results in time series in a tabular form. The determination result data of FIG. 15 includes a determination result of performing determination per month from March to August of 2018. With the determination result data of FIG. 15, determination results can be comprehensively confirmed in time series for each battery unit.

The output device 109 may output data indicating the value of each ratio together with the determination result data as in FIG. 14 or FIG. 15, or separately from such determination result data.

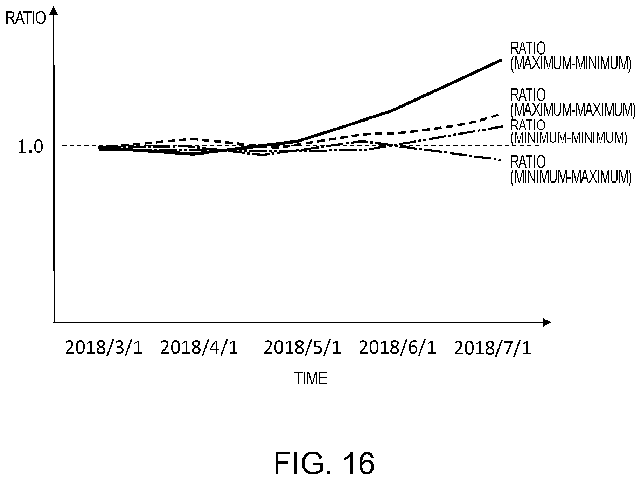

FIG. 16 illustrates an output example of data including the value of each ratio in time series. The data is shown in a graph form. The vertical axis is values of the ratios, and the horizontal axis is times. However, the horizontal axis may be a value indicating an operation quantity of the rechargeable battery such as Ah or Wh (for example, an accumulated value of charged and discharged electric current). In addition, the horizontal axis may be a number of cycles obtained by dividing the operation quantity by a rated value. Alternatively, the operation quantity and the number of cycles may be combined for output.

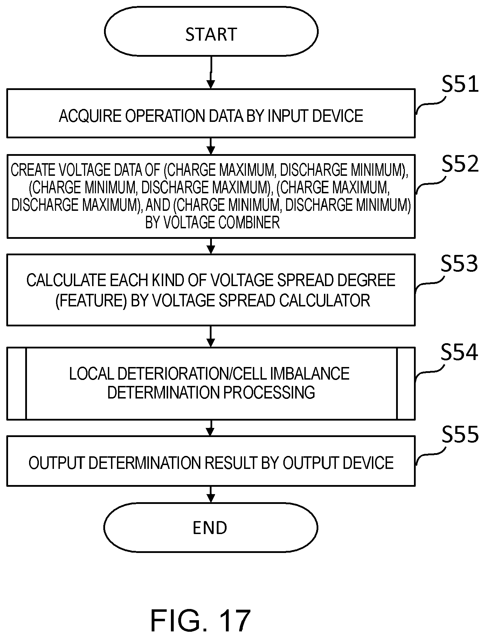

FIG. 17 illustrates a flowchart of a working example of the rechargeable battery monitor apparatus 100 according to the present embodiment. The input device 102 reads the operation data in a period which is the evaluation target from the operation DB 101 (S51). The voltage combiner 103 causes the specification devices 104, 105 to specify, for each operation data, the charge maximum voltage, the discharge minimum voltage, the charge minimum voltage, and the discharge maximum voltage. The voltage combiner 103 combines these specified voltages, and generates a set of charge maximum voltages and discharge minimum voltages, a set of charge minimum voltages and discharge maximum voltages, a set of charge maximum voltages and discharge maximum voltages, and a set of charge minimum voltages and discharge minimum voltages. Furthermore, for each operation data, the average voltage is calculated, and a set of average charge voltages and average discharge voltages is generated (S52). The voltage spread calculator 106 calculates, based on a voltage distribution of each set, voltage spread degrees (maximum-minimum), (minimum-maximum), (maximum-maximum), (minimum-minimum), and (average) as features (S53). The determiner 108 calculates a ratio of each of the voltage spread degrees (maximum-minimum), (minimum-maximum), (maximum-maximum), and (minimum-minimum) to the voltage spread degree (average), thereby acquiring ratios (maximum-minimum), (minimum-maximum), (maximum-maximum), and (minimum-minimum). The determiner 108 executes the processings illustrated in FIG. 13 based on the acquired ratios (maximum-minimum), (minimum-maximum), (maximum-maximum), and (minimum-minimum) to determine presence/absence of an anomaly. The output device 109 outputs data (determination result data) including a determination result by the determiner 108.

As described above, according to the present embodiment, occurrence of local deterioration and cell imbalance in the rechargeable battery can be determined without accumulating data (for example, voltage data) of all battery cells included in the rechargeable battery.

### (SECOND EMBODIMENT)

In the present embodiment, the lower limit threshold and the upper limit threshold used in the first embodiment are decided by learning.

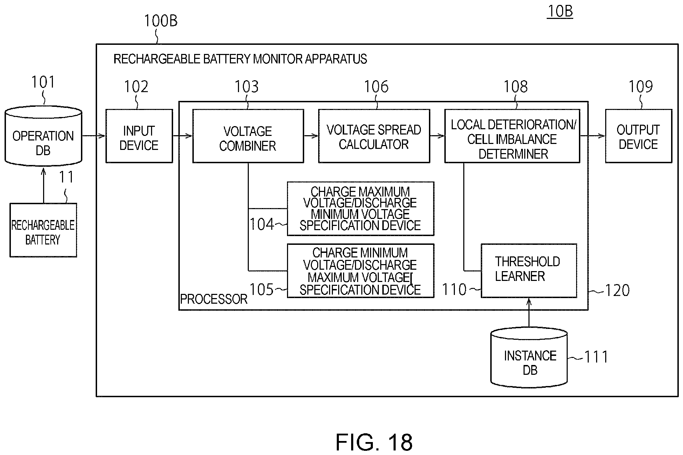

FIG. 18 illustrates an example of an information processing system 10B including a rechargeable battery monitor apparatus 100B as an information processing apparatus according to a second embodiment. A threshold learner 110 and an instance DB 111 are added to the rechargeable battery monitor apparatus 100 of FIG. 1.

The instance DB 111 stores instance data created based on the operation data. The operation data which is a generator of the instance data may be operation data different from the operation DB 101 storing the operation data which is the evaluation target. The instance data may be stored on the instance DB 111 in advance, or the present apparatus 100B may generate the instance data from the operation data. Note that, in this case, the operation data is made to correspond with presence/absence of occurrence of cell imbalance and local deterioration.

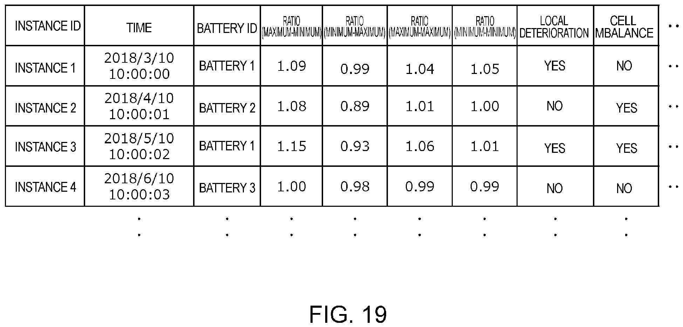

FIG. 19 illustrates an example of the instance data. An instance ID imparted to each instance, a battery ID, a value of each kind of the ratios, presence/absence of occurrence of cell imbalance, and presence/absence of occurrence of local deterioration are stored. The instance DB 111 stores an instance where cell imbalance is occurring, an instance where local deterioration is occurring, an instance where both of these are occurring, and an instance where neither of these is occurring. One operation data corresponds to one instance. Although presence/absence of occurrence of local deterioration and presence/absence of occurrence of cell imbalance are expressed by binary, a value obtained by quantifying degrees of occurrence may be used. For example, in the case of the local deterioration, a difference between the SoH of a battery cell which is least deteriorated and the SoH of a battery cell in which deterioration is most progressed may be used. In the case of the cell imbalance, a difference between the SoC of a battery cell having the largest amount of charge and the SoC of a battery cell having the smallest amount of charge may be used. In addition, instead of each kind of the ratios, operation data may be associated. In that case, each kind of the ratios may be calculated from the operation data.

The threshold learner 110 learns the lower limit threshold and the upper limit threshold based on the instance data. For example, when performing anomaly determination with the procedure of FIG. 13, the lower limit threshold and the upper limit threshold are decided such that the determination result becomes correct along the procedure of FIG. 13. For example, in the branching of step S11 in FIG. 13, when the ratio (maximum-minimum) is about 1 (the lower limit threshold or more and the upper limit threshold or less), it is decided that neither local deterioration nor cell imbalance is occurring. Thus, the lower limit threshold and the upper limit threshold are decided such that this decision becomes correct. Specifically, the lower limit threshold and the upper limit threshold should be decided such that a sorting index such as precision or recall becomes high.

The determiner 108 uses the lower limit threshold and the upper limit threshold decided by the threshold learner 110 to perform determination based on the procedure of FIG. 13 or the determination table of FIG. 8.

A method of determining local deterioration and cell imbalance may be other than the method based on the procedure of FIG. 13 or the determination table of FIG. 8. For example, if instances are sufficiently accumulated in the instance DB 111, a sorting model in which each ratio is used as an explanatory variable and presence/absence of occurrence of each of local deterioration and cell imbalance is used as an objective variable may be generated by machine learning. The determiner 108 decides presence/absence of occurrence of each of local deterioration and cell imbalance based on each kind of the ratios calculated from the operation data and the model generated by learning. Examples of the sorting model include a decision tree, logistic regression, a neighborhood method, a support vector machine, a neural network, a random forest, and the like.

In addition, there also may be a method of determining presence/absence of occurrence of local deterioration and cell imbalance without calculating each kind of the ratios. For example, for each occurrence pattern of an anomaly in the instance data (only local deterioration is occurring, only cell imbalance is occurring, both of these are occurring, and neither of these is occurring), each kind of the voltage distributions is plurally prepared. A neural network in which voltages included in any kind of the voltage distributions or voltages included in all kinds of the voltage distributions are used as input and presence/absence of occurrence of each of local deterioration and cell imbalance is used as output, is generated by machine learning. By inputting any kind or all kinds of the voltage distributions obtained based on the operation data to the generated neural network, presence/absence of occurrence of each of local deterioration and cell imbalance is estimated.

### (THIRD EMBODIMENT)

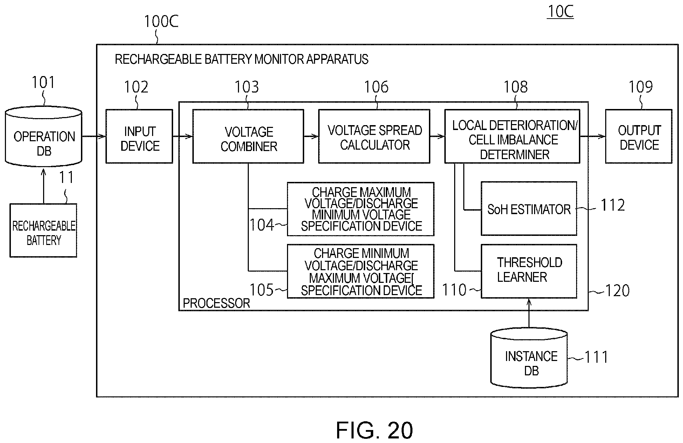

FIG. 20 illustrates an example of an information processing system 10C including a rechargeable battery monitor apparatus 100C as an information processing apparatus according to a third embodiment. An SoH estimator 112 is added to the rechargeable battery monitor apparatus 100B according to the second embodiment. The SoH estimator 112 may be added to the rechargeable battery monitor apparatus 100 according to the first embodiment or the rechargeable battery monitor apparatus 100A which is its modification.

The SoH estimator 112 estimates a State of Health (SoH) from each of the voltage spread degrees (maximum-minimum), (minimum-maximum), (maximum-maximum), (minimum-minimum), and (average). A ratio (rate) of the SoH estimated from the voltage spread degrees (maximum-minimum), (minimum-maximum), (maximum-maximum), and (minimum-minimum) to the SoH estimated from the voltage spread degree (average) is calculated. Since the voltage spread degrees correlate with deterioration states (SoH) of the rechargeable battery, for each of the voltage spread degrees (maximum-minimum), (minimum-maximum), (maximum-maximum), (minimum-minimum), and (average), a model for estimating the SoH from the voltage spread degree can be learned beforehand. The SoH estimator 112 estimates each SoH based on a value of each voltage spread degree and an already learned model corresponding to each voltage spread degree. As a method of estimating the SoH from the voltage spread degrees, an SoH estimation method disclosed in Japanese Patent No. 6313502 or International Publication No. WO2021/186512 may be used. The voltage spread degrees may vary depending on the temperature or the charge and discharge command value pattern mentioned above of the rechargeable battery, but these influences can be reduced by using the SoH. Thus, more stable anomaly determination is expected to be performed by calculating the ratios using the SoH. Note that when calculating the ratios using the SoH, comparison of whether the ratios are greater than the upper limit threshold and comparison of whether the ratios are smaller than the lower limit threshold in the determination table of FIG. 8 become opposite. For example, in the case of the ratio (maximum-minimum), ">1+α2" (greater than the upper limit threshold) corresponding to "local deterioration is occurring" (CASE 2) is changed to "<1-α1" (smaller than the lower limit threshold).

### (HARDWARE CONFIGURATION)

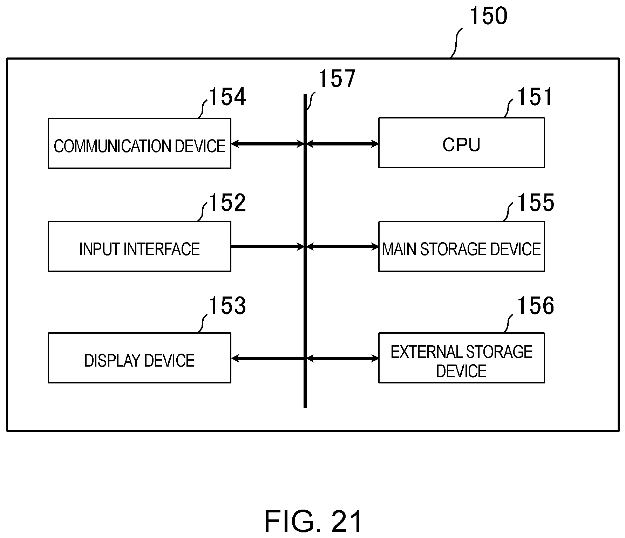

FIG. 21 illustrates a hardware configuration example of a rechargeable battery monitor apparatus according to an embodiment of the present invention. This hardware configuration can be used for the rechargeable battery monitor apparatuses 100, 100A, 100B, and 100C according to each embodiment mentioned above. The hardware configuration of FIG. 21 is formed as a computer 150. The computer 150 includes a CPU 151, an input interface 152, a display device 153, a communication device 154, a main storage device 155, and an external storage device 156, and these are connected in a manner communicable with each other via a bus 157.

The input interface 152 acquires measurement data of the rechargeable battery via wiring or the like. The input interface 152 may be a manipulation device for enabling a user to give an instruction to the present apparatus. Examples of the manipulation device include a keyboard, a mouse, and a touch panel. The communication device 154 includes a wireless or wired communicator, and wired or wireless communication with an EV 200 is performed. The measurement data may be acquired via the communication device 154. The input interface 152 and the communication device 154 each may be formed of a circuit such as a separate integrated circuit, or may be formed of a circuit such as a single integrated circuit. The display device 153 is, for example, a liquid crystal display device, an organic EL display device, a CRT display device, or the like. The display device 153 corresponds to the output device 109 of FIG. 1.

The external storage device 156 includes, for example, a storage medium such as an HDD, a SSD, a memory apparatus, CD-R, CD-RW, DVD-RAM, or DVD-R, and the like. The external storage device 156 stores a program for causing the CPU 151, which is a processor, to execute a function of each processor of the rechargeable battery monitor apparatus. In addition, each DB provided for the rechargeable battery monitor apparatus is also included in the external storage device 156. Although only one external storage device 156 is shown herein, more than one external storage devices 156 may exist.

The main storage device 155 develops a control program stored on the external storage device 156 under control by the CPU 151, and stores data that is needed when executing the program, data that is generated by the execution of the program, and the like. The main storage device 155 includes any memory or storage such as, for example, a volatile memory (DRAM, SRAM, or the like) or a nonvolatile memory (a NAND flash memory, MRAM, or the like). With the control program developed in the main storage device 155 being executed by the CPU 151, the function of each processor of the rechargeable battery monitor apparatus is executed. Each DB provided for the rechargeable battery monitor apparatus may also be included in the main storage device 155.

While certain arrangements have been described, these arrangements have been presented by way of example only, and are not intended to limit the scope of the inventions. Indeed, the apparatuses* described herein may be embodied in a variety of other forms; furthermore various omissions, substitutions and changes in the form of the apparatuses described herein may be made.

The embodiments as described before may be configured as below.

### (Clauses)

Clause 1. An information processing apparatus comprising a processor, wherein the processor is configured to:
   acquire a plurality of pieces of operation data each including a minimum voltage among voltages of a plurality of battery cells in a rechargeable battery, and a maximum voltage among the voltages of the plurality of battery cells, the plurality of battery cells, and identification information identifying charge or discharge showing whether the rechargeable battery is charged or discharged;
   generate, based on the plurality of pieces of operation data, evaluation target voltages by combining
      one of: maximum voltages in the pieces of operation data of the charge; and minimum voltages in the pieces of operation data of the charge and
      one of: maximum voltages of the discharge in the pieces of operation data; and minimum voltages of the discharge in the pieces of operation data; and
   determine a state of the rechargeable battery based on a voltage distribution of the evaluation target voltages.
Clause 2. The information processing apparatus according to clause 1, wherein the processor generates, as the evaluation target voltages, first voltages obtained by combining the minimum voltages of the charge and the maximum voltages of the discharge, and based on the first voltages, determines whether cell imbalance is occurring as the state of the rechargeable battery, the cell imbalance being variation in amounts of charge of the plurality of battery cells.
Clause 3. The information processing apparatus according to clause 2, wherein the processor generates, as the evaluation target voltages, second voltages obtained by combining the maximum voltages of the charge and the maximum voltages of the discharge, and based on the second voltages, determines whether local deterioration is also occurring at a same time as the cell imbalance, the local deterioration being local deterioration of some of the plurality of battery cells.
Clause 4. The information processing apparatus according to clause 2 or 3, wherein the processor generates, as the evaluation target voltages, third voltages obtained by combining the minimum voltages of the charge and the minimum voltages of the discharge, and based on the third voltages, determines whether the local deterioration is also occurring at the same time as the cell imbalance.
Clause 5. The information processing apparatus according to clause 3 or 4, wherein the processor generates, as the evaluation target voltages, fourth voltages obtained by combining the maximum voltages of the charge and the minimum voltages of the discharge, and based on the fourth voltages, determines whether at least either the cell imbalance or the local deterioration is occurring.
Clause 6. The information processing apparatus according to any one of clauses 1 to 5, wherein
   the operation data includes voltages of the rechargeable battery or average voltages of the plurality of battery cells at a time of the charge or the discharge,
   the processor calculates or acquires the average voltages of the plurality of battery cells based on the pieces of operation data, and calculates a voltage distribution of the average voltages of the plurality of battery cells at the time of the charge and the discharge, and
   the state of the rechargeable battery is determined by comparing the voltage distribution of the evaluation target voltages and the voltage distribution of the average voltages.
Clause 7. The information processing apparatus according to clause 6, wherein the processor calculates a feature representing spread of the voltage distribution of the evaluation target voltages and a reference feature representing spread of the voltage distribution of the average voltages, and determines the state of the rechargeable battery based on a ratio of the feature to the reference feature which are calculated.
Clause 8. The information processing apparatus according to clause 7, wherein the processor compares the ratio with at least one threshold to determine the state of the rechargeable battery.
Clause 9. The information processing apparatus according to clause 8, wherein the processor generates, as the evaluation target voltages, first voltages obtained by combining the minimum voltages of the charge and the maximum voltages of the discharge, and compares a first ratio of a first feature representing spread of a voltage distribution of the first voltages to the reference feature with the at least one threshold, to determine whether cell imbalance is occurring, the cell imbalance being variation in amounts of charge of the plurality of battery cells.
Clause 10. The information processing apparatus according to clause 9, wherein the processor further generates, as the evaluation target voltages, second voltages obtained by combining the maximum voltages of the charge and the maximum voltages of the discharge, and compares a second ratio of a second feature representing spread of a voltage distribution of the second voltages to the reference feature with the at least one threshold, to determine whether local deterioration is also occurring at the same time as the cell imbalance, the local deterioration being local deterioration of some of the plurality of battery cells.
Clause 11. The information processing apparatus according to clause 9 or 10, wherein the processor further generates, as the evaluation target voltages, third voltages obtained by combining the minimum voltages of the charge and the minimum voltages of the discharge, and compares a third ratio of a third feature representing spread of a voltage distribution of the third voltages to the reference feature with the at least one threshold, to determine whether the local deterioration is also occurring at the same time as the cell imbalance.
Clause 12. The information processing apparatus according to clause 10 or 11, wherein the processor further generates, as the evaluation target voltages, fourth voltages obtained by combining the maximum voltages of the charge and the minimum voltages of the discharge, and compares a fourth ratio of a fourth feature representing spread of a voltage distribution of the fourth voltages to the reference feature with the at least one threshold, to determine whether at least either the cell imbalance or the local deterioration is occurring.
Clause 13. The information processing apparatus according to any one of clauses 7 to 12, wherein the processor estimates an SoH of the rechargeable battery based on the feature, and estimates a reference SoH which is an SoH of the rechargeable battery based on the reference feature, to determine the state of the rechargeable battery based on a rate of the SoH with respect to the reference SoH.
Clause 14. The information processing apparatus according to clause 13, wherein the processor compares the ratio with at least one threshold to determine the state of the rechargeable battery.
Clause 15. The information processing apparatus according to clause 14, wherein the processor generates, as the evaluation target voltages, first voltages obtained by combining the minimum voltages of the charge and the maximum voltages of the discharge, and based on a first ratio of a first feature representing spread of a voltage distribution of the first voltages to the reference feature, determines whether cell imbalance is occurring as the state of the rechargeable battery, the cell imbalance being variation in amounts of charge of the plurality of battery cells.
Clause 16. The information processing apparatus according to clause 15, wherein the processor further generates, as the evaluation target voltages, second voltages obtained by combining the maximum voltages of the charge and the maximum voltages of the discharge, and compares a second ratio of a second feature representing spread of a voltage distribution of the second voltages to the reference feature with the at least one threshold, to determine whether local deterioration is also occurring at the same time as the cell imbalance, the local deterioration being local deterioration of some of the plurality of battery cells.
Clause 17. The information processing apparatus according to clause 15 or 16, wherein the processor further generates, as the evaluation target voltages, third voltages obtained by combining the minimum voltages of the charge and the minimum voltages of the discharge, and compares a third ratio of a third feature representing spread of a voltage distribution of the third voltages to the reference feature with the at least one threshold, to determine whether the local deterioration is also occurring at the same time as the cell imbalance.
Clause 18. The information processing apparatus according to clause 16 or 17, wherein the processor further generates, as the evaluation target voltages, fourth voltages obtained by combining the maximum voltages of the charge and the minimum voltages of the discharge, and compares a fourth ratio of a fourth feature representing spread of a voltage distribution of the fourth voltages to the reference feature with the at least one threshold, to determine whether at least either the cell imbalance or the local deterioration is occurring.
Clause 19. The information processing apparatus according to any one of clauses 8 to 18, wherein the processor decides the at least one threshold based on a temperature of the rechargeable battery or a charge and discharge command value pattern of the rechargeable battery.
Clause 20. The information processing apparatus according to any one of clauses 8 to 19, wherein the processor learns the at least one threshold based on a plurality of pieces of instance data including the first ratio, the second ratio, the third ratio, the fourth ratio, presence/absence of the cell imbalance, and presence/absence of the local deterioration.
Clause 21. An information processing method comprising:
   acquiring a plurality of pieces of operation data each including a minimum voltage among voltages of a plurality of battery cells in a rechargeable battery, and a maximum voltage among the voltages of the plurality of battery cells, and identification information identifying charge or discharge showing whether the rechargeable battery is charged or discharged;
   generating, based on the plurality of pieces of operation data, evaluation target voltages by combining
      one of: maximum voltages in the pieces of operation data of the charge; and minimum voltages in the pieces of operation data of the charge and
      one of: maximum voltages of the discharge in the pieces of operation data; and minimum voltages of the discharge in the pieces of operation data; and
   determining a state of the rechargeable battery based on a voltage distribution of the evaluation target voltages.
Clause 22. A non-transitory computer readable medium having a computer program stored therein which causes a computer to perform processes comprising:
   acquiring a plurality of pieces of operation data each including a minimum voltage among voltages of a plurality of battery cells in a rechargeable battery, and a maximum voltage among the voltages of the plurality of battery cells, and identification information identifying charge or discharge showing whether the rechargeable battery is charged or discharged;
   generating, based on the plurality of pieces of operation data, evaluation target voltages by combining
      one of: maximum voltages in the pieces of operation data of the charge; and minimum voltages in the pieces of operation data of the charge and
      one of: maximum voltages of the discharge in the pieces of operation data; and minimum voltages of the discharge in the pieces of operation data; and
   determining a state of the rechargeable battery based on a voltage distribution of the evaluation target voltages.
Clause 23. An information processing system comprising:
   a rechargeable battery including a plurality of battery cells; and
   a processor configured to
   acquire a plurality of pieces of operation data each including a minimum voltage among voltages of a plurality of battery cells in a rechargeable battery, and a maximum voltage among the voltages of the plurality of battery cells, and identification information identifying charge or discharge showing whether the rechargeable battery is charged or discharged;
   generate, based on the plurality of pieces of operation data, evaluation target voltages by combining
      one of: maximum voltages in the pieces of operation data of the charge; and minimum voltages in the pieces of operation data of the charge and
      one of: maximum voltages of the discharge in the pieces of operation data; and minimum voltages of the discharge in the pieces of operation data; and
   determine a state of the rechargeable battery based on a voltage distribution of the evaluation target voltages.

### [Reference Signs List]

1~N: BATTERY UNIT (BATTERY PACK, RECHARGEABLE BATTERY)
1-1~1-M MODULE (RECHARGEABLE BATTERY)
10, 10A, 10B, 10C INFORMATION PROCESSING SYSTEM
11 RECHARGEABLE BATTERY
100, 100A, 100B, 100C RECHARGEABLE BATTERY MONITOR APPARATUS
101 OPERATION DB
102 INPUT DEVICE
103 VOLTAGE COMBINER
104 CHARGE MAXIMUM VOLTAGE/DISCHARGE MINIMUM VOLTAGE SPECIFICATION DEVICE
105 CHARGE MINIMUM VOLTAGE/DISCHARGE MAXIMUM VOLTAGE SPECIFICATION DEVICE
106 VOLTAGE SPREAD CALCULATOR (FEATURE CALCULATOR)
107 FEATURE KIND DECIDER
108 LOCAL DETERIORATION/CELL IMBALANCE DETERMINER (DETERMINER)
109 OUTPUT DEVICE
110 THRESHOLD LEARNER
111 INSTANCE DB
112 SOH ESTIMATOR
120 PROCESSOR
150 COMPUTER
152 INPUT INTERFACE
153 DISPLAY DEVICE
154 COMMUNICATION DEVICE
155 MAIN STORAGE DEVICE
156 EXTERNAL STORAGE DEVICE
157 BUS
201 BATTERY SYSTEM
C CELL

## Claims

1. An information processing apparatus comprising a processor,
wherein the processor is configured to:
acquire a plurality of pieces of operation data each including a minimum voltage among voltages of a plurality of battery cells in a rechargeable battery, and a maximum voltage among the voltages of the plurality of battery cells, the plurality of battery cells, and identification information identifying charge or discharge showing whether the rechargeable battery is charged or discharged;
generate, based on the plurality of pieces of operation data, evaluation target voltages by combining
one of: maximum voltages in the pieces of operation data of the charge; and minimum voltages in the pieces of operation data of the charge and
one of: maximum voltages of the discharge in the pieces of operation data; and minimum voltages of the discharge in the pieces of operation data; and
determine a state of the rechargeable battery based on a voltage distribution of the evaluation target voltages.

2. The information processing apparatus according to claim 1, wherein the processor generates, as the evaluation target voltages, first voltages obtained by combining the minimum voltages of the charge and the maximum voltages of the discharge, and based on the first voltages, determines whether cell imbalance is occurring as the state of the rechargeable battery, the cell imbalance being variation in amounts of charge of the plurality of battery cells.

3. The information processing apparatus according to claim 2, wherein the processor generates, as the evaluation target voltages, second voltages obtained by combining the maximum voltages of the charge and the maximum voltages of the discharge, and based on the second voltages, determines whether local deterioration is also occurring at a same time as the cell imbalance, the local deterioration being local deterioration of some of the plurality of battery cells.

4. The information processing apparatus according to claim 3, wherein the processor generates, as the evaluation target voltages, third voltages obtained by combining the minimum voltages of the charge and the minimum voltages of the discharge, and based on the third voltages, determines whether the local deterioration is also occurring at the same time as the cell imbalance.

5. The information processing apparatus according to claim 4, wherein the processor generates, as the evaluation target voltages, fourth voltages obtained by combining the maximum voltages of the charge and the minimum voltages of the discharge, and based on the fourth voltages, determines whether at least either the cell imbalance or the local deterioration is occurring.

6. The information processing apparatus according to claim 1, wherein
the operation data includes voltages of the rechargeable battery or average voltages of the plurality of battery cells at a time of the charge or the discharge,
the processor calculates or acquires the average voltages of the plurality of battery cells based on the pieces of operation data, and calculates a voltage distribution of the average voltages of the plurality of battery cells at the time of the charge and the discharge, and
the state of the rechargeable battery is determined by comparing the voltage distribution of the evaluation target voltages and the voltage distribution of the average voltages.

7. The information processing apparatus according to claim 6, wherein the processor calculates a feature representing spread of the voltage distribution of the evaluation target voltages and a reference feature representing spread of the voltage distribution of the average voltages, and determines the state of the rechargeable battery based on a ratio of the feature to the reference feature which are calculated.

8. The information processing apparatus according to claim 7, wherein the processor compares the ratio with at least one threshold to determine the state of the rechargeable battery.

9. The information processing apparatus according to claim 8, wherein the processor generates, as the evaluation target voltages, first voltages obtained by combining the minimum voltages of the charge and the maximum voltages of the discharge, and compares a first ratio of a first feature representing spread of a voltage distribution of the first voltages to the reference feature with the at least one threshold, to determine whether cell imbalance is occurring, the cell imbalance being variation in amounts of charge of the plurality of battery cells.

10. The information processing apparatus according to claim 9, wherein the processor further generates, as the evaluation target voltages, second voltages obtained by combining the maximum voltages of the charge and the maximum voltages of the discharge, and compares a second ratio of a second feature representing spread of a voltage distribution of the second voltages to the reference feature with the at least one threshold, to determine whether local deterioration is also occurring at the same time as the cell imbalance, the local deterioration being local deterioration of some of the plurality of battery cells.

11. The information processing apparatus according to claim 10, wherein the processor further generates, as the evaluation target voltages, third voltages obtained by combining the minimum voltages of the charge and the minimum voltages of the discharge, and compares a third ratio of a third feature representing spread of a voltage distribution of the third voltages to the reference feature with the at least one threshold, to determine whether the local deterioration is also occurring at the same time as the cell imbalance.

12. The information processing apparatus according to claim 11, wherein the processor further generates, as the evaluation target voltages, fourth voltages obtained by combining the maximum voltages of the charge and the minimum voltages of the discharge, and compares a fourth ratio of a fourth feature representing spread of a voltage distribution of the fourth voltages to the reference feature with the at least one threshold, to determine whether at least either the cell imbalance or the local deterioration is occurring.

13. The information processing apparatus according to claim 7, wherein the processor estimates an SoH of the rechargeable battery based on the feature, and estimates a reference SoH which is an SoH of the rechargeable battery based on the reference feature, to determine the state of the rechargeable battery based on a rate of the SoH with respect to the reference SoH.

14. The information processing apparatus according to claim 13, wherein the processor compares the ratio with at least one threshold to determine the state of the rechargeable battery.

15. The information processing apparatus according to claim 14, wherein the processor generates, as the evaluation target voltages, first voltages obtained by combining the minimum voltages of the charge and the maximum voltages of the discharge, and based on a first ratio of a first feature representing spread of a voltage distribution of the first voltages to the reference feature, determines whether cell imbalance is occurring as the state of the rechargeable battery, the cell imbalance being variation in amounts of charge of the plurality of battery cells.

16. The information processing apparatus according to claim 15, wherein the processor further generates, as the evaluation target voltages, second voltages obtained by combining the maximum voltages of the charge and the maximum voltages of the discharge, and compares a second ratio of a second feature representing spread of a voltage distribution of the second voltages to the reference feature with the at least one threshold, to determine whether local deterioration is also occurring at the same time as the cell imbalance, the local deterioration being local deterioration of some of the plurality of battery cells.

17. The information processing apparatus according to claim 16, wherein the processor further generates, as the evaluation target voltages, third voltages obtained by combining the minimum voltages of the charge and the minimum voltages of the discharge, and compares a third ratio of a third feature representing spread of a voltage distribution of the third voltages to the reference feature with the at least one threshold, to determine whether the local deterioration is also occurring at the same time as the cell imbalance.

18. The information processing apparatus according to claim 17, wherein the processor further generates, as the evaluation target voltages, fourth voltages obtained by combining the maximum voltages of the charge and the minimum voltages of the discharge, and compares a fourth ratio of a fourth feature representing spread of a voltage distribution of the fourth voltages to the reference feature with the at least one threshold, to determine whether at least either the cell imbalance or the local deterioration is occurring.

19. The information processing apparatus according to claim 8, wherein the processor decides the at least one threshold based on a temperature of the rechargeable battery or a charge and discharge command value pattern of the rechargeable battery.

20. The information processing apparatus according to claim 12, wherein the processor learns the at least one threshold based on a plurality of pieces of instance data including the first ratio, the second ratio, the third ratio, the fourth ratio, presence/absence of the cell imbalance, and presence/absence of the local deterioration.

21. An information processing method comprising:
acquiring a plurality of pieces of operation data each including a minimum voltage among voltages of a plurality of battery cells in a rechargeable battery, and a maximum voltage among the voltages of the plurality of battery cells, and identification information identifying charge or discharge showing whether the rechargeable battery is charged or discharged;
generating, based on the plurality of pieces of operation data, evaluation target voltages by combining
one of: maximum voltages in the pieces of operation data of the charge; and minimum voltages in the pieces of operation data of the charge and
one of: maximum voltages of the discharge in the pieces of operation data; and minimum voltages of the discharge in the pieces of operation data; and
determining a state of the rechargeable battery based on a voltage distribution of the evaluation target voltages.

22. A computer program which causes a computer to perform processes comprising:
acquiring a plurality of pieces of operation data each including a minimum voltage among voltages of a plurality of battery cells in a rechargeable battery, and a maximum voltage among the voltages of the plurality of battery cells, and identification information identifying charge or discharge showing whether the rechargeable battery is charged or discharged;
generating, based on the plurality of pieces of operation data, evaluation target voltages by combining
one of: maximum voltages in the pieces of operation data of the charge; and minimum voltages in the pieces of operation data of the charge and
one of: maximum voltages of the discharge in the pieces of operation data; and minimum voltages of the discharge in the pieces of operation data; and
determining a state of the rechargeable battery based on a voltage distribution of the evaluation target voltages.

23. An information processing system comprising:
a rechargeable battery including a plurality of battery cells; and
a processor configured to
acquire a plurality of pieces of operation data each including a minimum voltage among voltages of a plurality of battery cells in a rechargeable battery, and a maximum voltage among the voltages of the plurality of battery cells, and identification information identifying charge or discharge showing whether the rechargeable battery is charged or discharged;
generate, based on the plurality of pieces of operation data, evaluation target voltages by combining
one of: maximum voltages in the pieces of operation data of the charge; and minimum voltages in the pieces of operation data of the charge and
one of: maximum voltages of the discharge in the pieces of operation data; and minimum voltages of the discharge in the pieces of operation data; and
determine a state of the rechargeable battery based on a voltage distribution of the evaluation target voltages.
